Europäisches Patentamt

European Patent Office

Office européen des brevets

(19)

(11) Veröffentlichungsnummer: **0 201 019**
**B1**

(12)

# EUROPÄISCHE PATENTSCHRIFT

(45) Veröffentlichungstag der Patentschrift: **08.08.90**

(51) Int. Cl.⁵: **G 01 R 21/133**, G 01 R 35/04

(21) Anmeldenummer: **86105830.3**

(22) Anmeldetag: **28.04.86**

(54) **Statischer Elektrizitätszähler und Verfahren zu dessen Eichung.**

(30) Priorität: **02.05.85 CH 1854/85**

(43) Veröffentlichungstag der Anmeldung:
**12.11.86 Patentblatt 86/46**

(45) Bekanntmachung des Hinweises auf die
Patenterteilung:
**08.08.90 Patentblatt 90/32**

(84) Benannte Vertragsstaaten:
**AT BE DE FR GB IT NL SE**

(56) Entgegenhaltungen:
**EP-A-0 057 978**
**FR-A-2 381 317**

**IEEE TRANSACTIONS ON INDUSTRIAL
ELECTRONICS AND CONTROL
INSTRUMENTATION, Band IECI-28, Nr. 3,
August 1981, Seiten 180-184, IEEE, New York,
US; J.J. HILL et al.: "Design of a microprocessor-
based digital wattmeter"**

(73) Patentinhaber: **ZELLWEGER USTER AG
Wilstrasse 11
CH-8610 Uster (CH)**

(72) Erfinder: **Bär, Hanspeter, Dr.
Wannenstrasse 61
CH-8610 Uster (CH)**
Erfinder: **Durisch, Gion
Ackerstrasse 24
Ch-8610 Uster (CH)**

**Beschreibung**

Die Erfindung betrifft einen statischen Elektrizitätszähler mit einem elektronischen Messwerk, welches einen Analog/Digital-Wandler mit vorgeschalteten Verstärkern für verschiedene Messbereiche, einen Wattstundenzähler und einen Steuerteil mit einem Mikrocomputer aufweist, welcher die Verarbeitung der Signale des Messwerks unter Berücksichtigung von Korrekturwerten für die verschiedenen Elemente der Schaltung vornimmt.

Bei einem aus der DE—A—26 30 959 bekannten Elektrizitätszähler dieser Art werden sowohl Korrekturfaktoren zur Kompensation der Abweichung der Verstärkungsfaktoren der Verstärker abgespeichert, als auch die ganze Kennlinie des Stromwandlers mit beispielsweise 64 Stützwerten, als auch Korrekturfaktoren von anderen Elementen. Die Speicherung aller dieser Werte ist mit einem erheblichen Aufwand verbunden.

Durch die Erfindung soll nun ein Elektrizitätszähler angegeben werden, bei welchem möglichst wenig Korrekturwerte zu speichern sind, welche sich ausserdem noch möglichst einfach ermitteln lassen sollen.

Diese Aufgabe wird erfindungsgemäss dadurch gelöst, dass das Messwerk einen Speicherteil mit Korrekturregistern und mit Hilfsregistern aufweist, dass in den Korrekturregistern für jeden der Messbereiche eine Zählerkenngrösse gespeichert ist, welche einen einer definierten Energiemenge entsprechenden Zahlenwert repräsentiert und den jeweiligen Korrekturwert enthält, und dass die Bestimmung der Menge der verbrauchten Energie durch Vergleich der gemessenen und in einem Hilfsregister akkumulierten Energie mit der entsprechenden Zählerkenngrösse erfolgt.

Wenn der Zähler beispielsweise vier Verstärker für vier Messbereiche aufweist, dann brauchen lediglich vier Zählerkenngrössen gespeichert zu werden. Diese können durch einen konventionellen Eichvorgang ermittelt werden und ermöglichen die Kompensation sämtlicher konstanter Fehler der Signalverarbeitung.

Die Erfindung betrifft weiter ein Verfahren zur Eichung des genannten Elektrizitätszählers.

Das erfindungsgemässe Verfahren ist dadurch gekennzeichnet, dass man die Eichung separat für jeden Messbereich vornimmt, dabei zu Beginn den Wattstundenzähler und die Register auf Null stellt und anschliessend während einer bestimmten Zeitperiode an den Zähler eine definierte Eichspannung anlegt und ihm einen definierten Eichstrom zuführt, und dass man die bei der Eichung akkumulierte Energiemenge als Zählerkenngrösse für den betreffenden Bereich speichert.

Nachstehend wird die Erfindung anhand eines Ausführungsbeispiels und der Zeichnungen näher erläutert; es zeigen:

Fig. 1 ein Blockschaltbild eines Elektrizitätszählers, und

Fig. 2 ein Detail von Fig. 1.

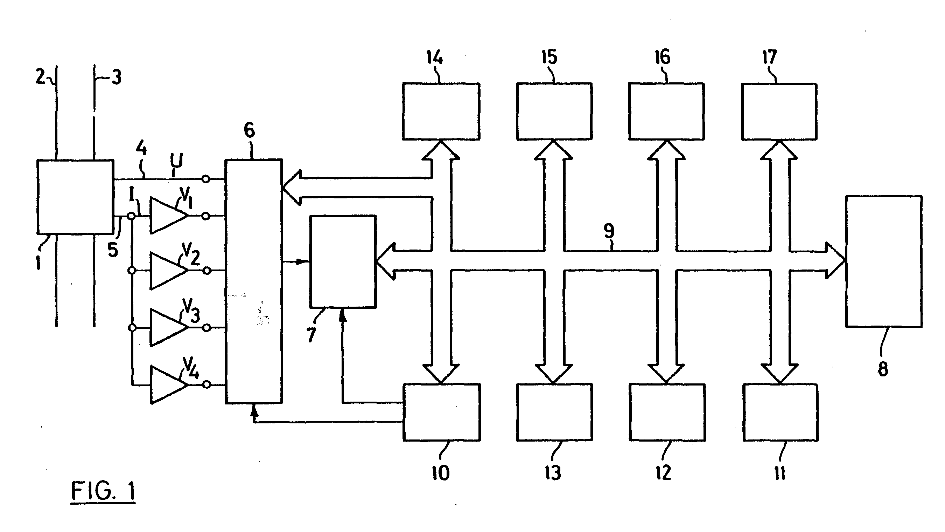

Der in Fig. 1 dargestellte statische Elektrizitätszähler ist über ein Eingangsmodul 1 mit zwei Leitungen 2 und 3 verbunden, welche einerseits vom Netz zum Zähler und anderseits vom Zähler zu den diversen elektrischen Geräten des Kunden führen. Das Eingangsmodul 1 erzeugt eine Vielzahl analoger Signale, welche dem augenblicklichen Wert von Strom I und Spannung U der Phasen in den Leitungen 2 und 3 proportional sind. Diese Signale sind an entsprechenden Ausgängen des Eingangsmoduls 2 erhältlich. Die der Spannung U proportionalen Signale werden über eine Leitung 4 direkt, und die Stromsignale I werden über eine Leitung 5 via eine Anzahl von darstellungsgemäss vier Verstärkern $V_1$ bis $V_4$ indirekt einem Multiplexer 6 zugeführt.

Die Verstärker $V_1$ bis $V_4$ weisen verschiedene Verstärkungsstufen auf und dienen zur Erweiterung des Messbereichs. Jeder dieser Verstärker verstärkt die Stromsignale derart, dass ein dem Multiplexer 6 nachgeschalteter A/D-Wandler 7 optimal angesteuert wird.

Die Verstärker $V_1$ bis $V_4$ sind beispielsweise für folgende Strombereiche vorgesehen:

<u>Tabelle 1</u>

| Verstärker | Bereich | Ströme | | | |
|---|---|---|---|---|---|
| $V_1$ | 1 | 20 | A - | 80 | A |
| $V_2$ | 2 | 5 | A - | 20 | A |
| $V_3$ | 3 | 1,25 | A - | 5 | A |
| $V_4$ | 4 | 0 | A - | 1,25 | A |

Der Multiplexer 6 und der A/D-Wandler 7 sind durch eine zentrale Recheneinheit 8 gesteuert, welche mit dem Multiplexer 6, dem A/D-Wandler 7 und anderen noch zu beschreibenden Elementen über einen Daten-, Adress- und Steuer-bus 9 verbunden ist. Bei einem Dreiphasen-Drehstromnetz beispielsweise besteht das Ausgangssignal des A/D-Wandlers 7 jeweils aus drei Strom- und aus drei Spannungs-Datenwörtern, welche dem Datenteil des Buses 9 nach in der konventionellen Datenverarbeitung üblichen Methoden zugeführt werden.

Eines der erwähnten Elemente, mit welchem die zentrale Recheneinheit 8 über den Bus 9 verbunden ist, ist ein Timer 10, welcher die Taktfrequenz für den Multiplexer 6 und den A/D-Wandler 7 liefert.

Die zentrale Recheneinheit 8 ist über den Bus 9 ausserdem mit einem Interface 11, einem Speichermedium 12, einer Echtzeit-Uhr 13, einem Display 14, einem ersten und einem zweiten programmierbaren Lese-Speicher (PROM) 15 bzw. 16 und mit einem Signalspeicher mit beliebigem Zugriff (RAM) 17 verbunden.

Das Interface 11 ist mit einem Daten-Ein/Ausgabegerät verbunden und ermöglicht die Uebertragung der Daten über ein Uebertragungssystem. Das Speichermedium 12 für die Daten kann beispeilsweise ein Magnetband, eine Magnetplatte oder ein Festkörperspeicher sein.

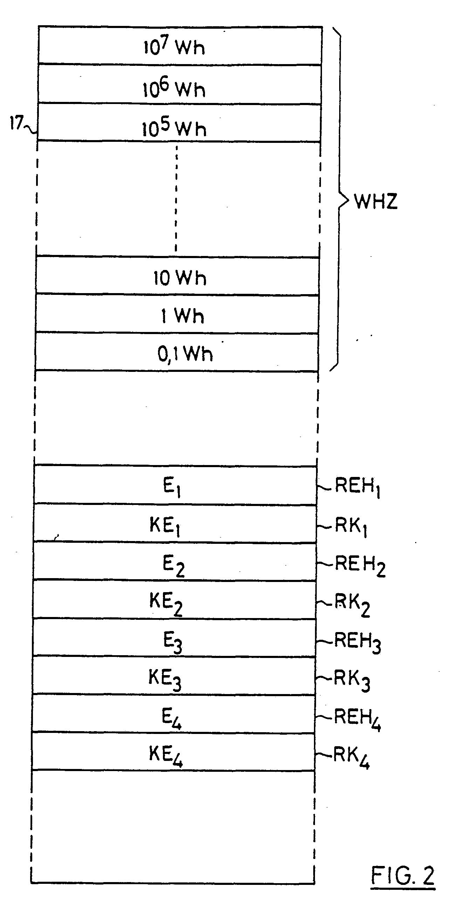

Die Echtzeituhr 13 wird für die Berechnung der verbrauchten Energiemengen auf Zeitbasis benötigt und das Display 14 dient zur Anzeige dieser Energiemengen. Das erste PROM 15 enthält Instruktionen und Daten, welche für alle die betreffenden Elektrizitätszähler benützenden Kunden gleich sind; das zweite PROM 16 enthält kundenspezifische Instruktionen und Daten, sein Inhalt ist also von Kunde zu Kunde mehr oder weniger verschieden. Das RAM 17 schliesslich enthält einen Wattstundenzähler und verschiedene interne Register, welche im Zusammenhang mit Fig. 2 beschrieben sind.

Verschiedene der beschriebenen Elemente, beispielsweise das Interface 11, das Speichermedium 12 und das zweite PROM 16 müssen nicht in jedem Fall vorhanden sein und können daher als Optionen betrachtet werden.

Da die Art und Weise der Verbindung einer zentralen Recheneinheit mit den verschiedenen in Fig. 1 dargestellten Elementen über einen Bus zum Verständnis des Fachmanns gehört, wird dies hier nicht näher erläutert. Bezüglich bekannter statischer Elektrizitätszähler wird auf die DE—B—28 31 407 und auf die EP-Patentanmeldungen Nr. EP—A—00 57 978 und EP—A—00 63 402 verwiesen. Ebenso wird auch der mechanische Aufbau des Elektrizitätszählers als bekannt vorausgesetzt. Es sei aber in diesem Zusammenhang darauf hingewiesen, dass der Zähler selbstverständlich weitere Elemente oder Bauteile enthalten kann. So könnte der Zähler beispielsweise einen Rundsteuerempfänger enthalten oder er könnte einen freien Platz für den nachträglichen Einbau eines Rundsteuerempfängers aufweisen. Im letzteren Fall wäre die gesamte den Rundsteuerempfänger betreffende software bereits im Zähler enthalten oder sie könnte in ein zweites PROM integriert sein, das dann beim nachträglichen Einbau des Rundsteuerempfängers das entsprechende PROM 16 ersetzen würde.

Es ist bekannt, dass bei Elektrizitätszählern Elemente mit nichtidealer Kennlinie, insbesondere Strom- und Spannungswandler sowie Verstärker, zu Messfehlern führen. Man versucht diese beispielsweise dadurch auszuschalten, dass man die Kennlinien des Stromwandlers sowie weitere Korrekturfaktoren zur Kompensation der Abweichung der Verstärkungsfaktoren der Verstärker abspeichert und die Signalverarbeitung unter Berücksichtigung aller dieser Korrekturwerte durchführt.

In der Art und Weise der Gewinnung der genannten Korrekturwerte und deren Berücksichtigung bei der Signalverarbeitung liegt das wesentliche Merkmal des vorliegenden Elektrizitätszählers. Bei diesem werden nicht ganze Kennlinien und eine Vielzahl weiterer Korrekturwerte gespeichert, sondern man ermittelt während des Eichvorgangs des Zählers für jeden der vier durch die Verstärker $V_1$ bis $V_4$ definierten Strombereiche den konstanten Fehler und programmiert den Zähler derart, dass der konstante Fehler im Normalbetrieb gerade kompensiert wird. Damit wird die Anzahl der zu speichernden und zu berücksichtigenden Korrekturwerte praktisch um Grössenordnungen reduziert.

Das in Fig. 2 dargestellte RAM 17 enthält einerseits einen Wattstundenzähler WHZ und andererseits Register $REH_i$ und $RK_i$, für je einen der vier Bereiche. Die Hilfsregister $REH_i$ dienen zur Akkumulierung der Energie $E_i$ in den einzelnen Bereichen und die Korrekturregister $RK_i$ enthalten die beim Eichprozess festgelegten Zählerkenngrössen $KE_i$, die den jeweiligen konstanten Fehler repräsentieren.

Zu Beginn der Eichphase werden die Register und der Wattstundenzähler auf Null gestellt und es beginnt die Eichung und zwar separat für jeden Verstärker $V_1$ bis $V_4$ (Fig. 1). Während einer bestimmten Zeitperiode wird an den Zähler eine festgelegte Eichspannung angelegt und es wird ihm ein festgelegter Eichstrom zugeführt. Dadurch erfasst der Zähler während der Eichperiode ein vorbestimmtes Energiequant.

Der Zähler tastet während der Eichung die Eingangssignale ab und digitalisiert sie und ermittelt durch geeignete numerische Verarbeitung (Multiplikation, Akkumulation) die Momentanleistung und die seit Eichbeginn akkumuierte Energie. Zur Akkumulierung wird das entsprechende Hilfsregister $REH_i$ verwendet.

Am Ende der Eichperiode entspricht dann der im Hilfsregister $REH_i$ enthaltene Wert definitionsgemäss genau dem Energiequant. Der im Hilfsregister $REH_i$ enthaltene Wert gilt fortan als Zählerkenngrösse $KE_i$, welche im zugeordneten Korrekturregister $RK_i$ gespeichert wird. Mit dem Transfer des Inhalts von $REH_i$ ins Register $RK_i$ ist der Eichvorgang für den betreffenden Bereich abgeschlossen.

Während des Eichvorgangs können beispielsweise folgende Spannungen und Ströme angelegt werden:

# EP 0 201 019 B1

## Tabelle 2

| Bereich | Spannung | Strom |
|---------|----------|-------|
| 1 | Nennspannung z.B. 220 V | 50 A |
| 2 | - " - | 12,5 A |
| 3 | - " - | 3,125 A |
| 4 | - " - | 0,78 A |

Wenn man die Werte von Tabelle 2 mit denjenigen von Tabelle 1 vergleicht, dann sieht man, dass die Eichströme in der Mitte des jeweiligen Bereichs liegen. Bei gewissem Fehlverhalten von Komponenten, beispielsweise bei nichtlinearem Verlauf der Kennlinie des Stromwandlers innerhalb eines Bereichs, empfiehlt es sich, den Eichstrom unsymmetrisch zu den Bereichsgrenzen zu wählen. Das Ziel ist dabei in jedem Fall eine Minimierung des maximalen Betrages des Messfehlers über den ganzen Bereich.

Sinnvolle Eichzeiten liegen im Bereich zwischen etwa 20 sec und 100 sec. Beisielsweise ergeben folgende Eichzeiten mit den Spannungs- und Stromwerten von Tabelle 2 folgende Kenngrössen $KE_i$:

## Tabelle 3

| Bereich | Eichdauer mit Eichstrom | Energiequant |
|---------|------------------------|--------------|
| 1 | ca. 52 sec | 10 Wh |
| 2 | ca. 21 sec | 1 Wh |
| 3 | ca. 84 sec | 1 Wh |
| 4 | ca. 34 sec | 0.1 Wh |

Wie sich durch Nachrechnen ermitteln lässt, ergibt sich bei den in Tabelle 3 angegebenen Werten eigentlich jeweils das 16-fache Energiequant, beispielsweise im Bereich 1: 220.50.52/3600 = 160 Wh. Der Zähler dividiert jedoch diesen Wert durch 16 und speichert das Resultat als bereichsabhängige Kenngrösse $KE_1$ ab.

Für die Eichung wird als Referenzgerät ein Eichzähler verwendet, der zu Beginn des Eichvorgangs ein Startsignal an den zu eichenden Zähler abgibt. Dann beginnen beide Zähler parallel mit der Berechnung der seit dem Startsignal resultierenden Energie. Beim Erreichen des 16-fachen Werts des gewünschten Energiequants gibt der Eichzähler an den zu eichenden Zähler ein Stoppsignal ab. Dieses löst die Division des akkumulierten Energiewerts durch 16 sowie die Abspeicherung des resultierenden Wertes als Zählerkenngrösse $KE_i$ im entsprechenden Korrekturregister $RK_i$ aus.

Im Betriebszustand des Zählers wird in den einzelnen Zellen des Wattstundenzählers WHZ (Fig. 2) die Anzahl der Wattstunden, darstellungsgemäss aufgeteilt in die relevanten Zehnerpotenzen, gespeichert. Der Inhalt einer Zelle liegt also zwischen 0 und 9. Im Wattstundenzähler WHZ und auch in den anderen Registern des RAM 17 muss die Grösse einer Zelle nicht notwendig mit einem Byte zu 8 Bits übereinstimmen. So genügen beispielsweise zur Darstellung des Bereichs 0 bis 9 im Wattstundenzähler WHZ 4 Bits; die Register $REH_i$ und $RK_i$ umfassen dagegen mehr als 1 Byte.

Das Hilfsregister $REH_1$ beispielsweise wird benötigt, um die Energie $E_1$ zu akkumulieren, wenn der Zähler den Strombereich 1 gewählt hat. Die Auswahl des jeweiligen Strombereichs erfolgt durch die zentrale Recheneinheit 8, welche anhand des Ausgangssignals des aktuellen Verstärkers $V_1$ bis $V_4$ gegebenenfalls einen anderen Verstärker ansteuert, wenn sich der Strom vergrössert oder verkleinert hat.

Das Korrekturregister $RK_1$ enthält die Zählerkenngrösse $KE_1$ deren Wert beim Eichprozess festgelegt worden ist. Gemäss Tabelle 3 entspricht der Wert von $KE_1$ genau 10 Wh.

Die zentrale Recheneinheit 8 des Zählers vergleicht wärend des Messvorgangs, d.h. jeweils nach einer Abtastung der Strom- und Spannungswerte und der Addition des resultierenden Produktwerts zum alten

4

EP 0 201 019 B1

Wert von $E_1$ den Wert von $E_1$ mit der Kenngrösse $KE_1$. Sobald $E_1$, also der Inhalt des Hilfsregisters $REH_1$, die im Korrekturregister $RK_1$ gespeicherte Zählerkenngrösse $KE_1$ übersteigt, wird die in der Zelle "10 Wh" des Wattstundenzählers WHZ gespeicherte Zahl um 1 erhöht und gegebenenfalls erfolgt ein Uebertrag in das nächst höhere Register $10^2$ Wh des Wasttstundenzählers WHZ. Gleichzeitig wird im Hilfsregister $REH_1$ vom Wert $E_1$ die zugeordnete Zählerkenngrösse $KE_1$ subtrahiert und der Akkumulierungsprozess läuft normal weiter.

Dieses für den Strombereich 1 beschriebene Verfahren gilt analog für die anderen Bereiche 2 bis 4.

Wenn während des Messvorgangs ein Bereichswechsel erforderlich wird, dann bleiben die Werte $E_i$ des vorherigen Bereichs erhalten bis der Zähler wieder in diesen alten vorherigen Bereich zurückkehrt.

Sowohl der Wattstundenzähler WHZ als auch die Hilfsregister $REH_i$ und die Korrekturregister $RK_i$ sind sogenannte non-volatile Memories, also nicht flüchtige Speicher.

**Patentansprüche**

1. Statischer Elektrizitätszähler mit einem elektronischen Messwerk, welches einen Analog/Digital-Wandler (7) mit vorgeschalteten Verstärkern ($V_1$ bis $V_4$) für verschiedene Messbereiche, einen Wattstundenzähler (WHZ) und einen Steuerteil mit einem Mikrocomputer (8) aufweist, welcher die Verarbeitung der Signale des Messwerks unter Berücksichtigung von Korrekturwerten für die verschiedenen Elemente der Schaltung vornimmt, dadurch gekennzeichnet, dass das Messerk einen Speicherteil (17) mit Korrekturregistern ($RK_i$) und mit Hilfsregistern ($REH_i$) aufweise, dass in den Korrekturregistern für jeden der Messbereiche eine Zählerkenngrösse ($KE_i$) gespeichert ist, welche einen einer definierten Energiemenge entsprechenden Zahlenwert repräsentiert und den jeweiligen Korrekturwert enthält, und dass die Bestimmung der Menge der verbrauchten Energie durch Vergleich der gemessenen und in einem der Hilfsregister ($REH_i$) akkumulierten Energie ($E_i$) mit der entsprechenden Zählerkenngrösse erfolgt.

2. Elektrizitätszähler nach Anspruch 1, dadurch gekennzeichnet, dass der Wattstundenzähler (WHZ) mehrere Zellen für verschiedene den Meßbereichen entsprechenden Wattstundenbereiche aufweist, und dass bei Ueberschreiten der jeweiligen Zählerkenngrösse ($KE_i$) durch die akkumulierte Energie ($E_i$) der der Zählerkenngrösse ($KE_i$) entsprechende Zahlenwert in die dieser Zählerkenngrösse zugeordnete Zelle des Wattstundenzählers eingegeben wird.

3. Elektrizitätszähler nach Anspruch 2, dadurch gekennzeichnet, dass bei der Eingabe des der Zählerkenngrösse ($KE_i$) entsprechenden Zahlenwertes in die entsprechende Zelle des Wattstundenzählers (WHZ) die im Hilfsregister akkumulierte Energie ($E_i$) um den Betrag der Zählerkenngrösse vermindert wird.

4. Elektrizitätszähler nach Anspruch 2 oder 3, dadurch gekennzeichnet, dass für jeden Messbereich jeweils ein Hilfsregister ($REH_i$) für die Akkumulierung der aktuellen Energie ($E_i$) sowie ein Korrekturregister ($RK_i$) mit der entsprechenden Zählerkenngrösse ($KE_i$) vorgesehen sind.

5. Elektrizitätszähler nach Anspruch 1, dadurch gekennzeichnet, dass der Speicherteil (17) durch einen Signalspeicher mit beliebigem Zugriff gebildet ist, und dass neben den Hilfsregistern ($REH_i$) und den Korrekturregistern ($RK_i$) auch der Wattstundenzähler (WHZ) in diesem enthalten ist.

6. Verfahren zue Eichung des Elektrizitätszählers nach Anspruch 1, dadurch gekennzeichnet, dass man die Eichung separat für jeden Messbereich vornimmt, dabei zu Beginn den Wattstundenzähler (WHZ) und die Register ($RK_i$, $REH_i$) auf Null stellt und anschliessend während einer bestimmten Zeitperiode an den Zähler eine definierte Eichspannung anlegt und ihm einen definierten Eichstrom zuführt, und dass man die bei der Eichung während dieser Zeitperiode akkumulierte Energiemenge ($E_i$) als Zählerkenngrösse ($KE_i$) für den betreffenden Messbereich speichert.

7. Verfahren nach Anspruch 6, dadurch gekennzeichnet, dass man die Energiemenge ($E_i$) in einem Hilfsregister ($REH_i$) akkumuliert und die Zählerkenngrösse ($KE_i$) in einem Korrekturregister ($RK_i$) speichert.

8. Verfahren nach Anspruch 6 oder 7, dadurch gekennzeichnet, dass man den Eichstrom so wählt, dass der maximale Betrag des Messfehlers innerhalb des jeweiligen Messbereichs minimiert wird.

9. Verfahren nach Anspruch 8, dadurch gekennzeichnet, dass man den Eichstrom so wählt, dass er dem Mittelwert des jeweiligen Messbereichs entspricht.

**Revendications**

1. Compteur statique d'électricité avec un système électronique de mesure, qui présente un convertisseur analogique/numérique (7) avec amplificateurs en série ($V_1$ à $V_4$) pour diverses plages de mesure, un compteur de wattheures (WHZ) et une pièce de commande avec un micro-ordinateur (8), qui entreprend le traitement des signaux du système de mesure en considérant des valeurs de correction pour les divers éléments du circuit, caractérisé en ce que le système de mesure présente une partie de mémorisation (17) avec registres de correction ($RK_i$) et avec registres auxiliaires ($REH_i$), en ce que dans les registres de correction pour chacune des plages de mesure est mémorisée une grandeur caractéristique de compteur ($KE_i$) qui représente une valeur de compteur correspondant à une masse définie d'énergie et contient chaque valeur de correction et en ce que la détermination de la masse de l'énergie utilisée se produit par comparaison de l'énergie mesurée et accumulée ($E_i$) dans l'un des registres auxiliaires ($REH_i$) avec la grandeur caractéristique de compteur correspondante.

5

2. Compteur d'électricité selon la revendication 1, caractérisé en ce que le compteur de wattheures (WHZ) présente plusieurs cellules pour diverses plages de wattheures correspondant aux plages de mesure et en ce que lorsqu'une grandeur caractéristique de compteur ($KE_i$) est dépassée par l'énergie accumulée ($E_i$), la valeur de compteur correspondant à cette grandeur caractéristique de compteur ($KE_i$) est introduite à la cellule du compteur de wattheures affectée à cette grandeur caractéristique du compteur.

3. Compteur d'électricité selon la revendication 2, caractérisé en ce qu'à l'introduction de la valeur de compteur correspondant à la grandeur caractéristique du compteur ($KE_i$) dans la cellule correspondante du compteur de wattheures (WHZ), l'énergie ($E_i$) accumulée dans le registre auxiliaire se trouve diminuée du montant de la grandeur caractéristique du compteur.

4. Compteur d'électricité selon la revendication 2 ou 3, caractérisé en ce que pour chaque plage de mesure, sont prévus un registre auxiliaire ($REH_i$) pour l'accumulation de l'énergie actuelle ($E_i$) ainsi qu'un registre de correction ($RK_i$) avec la grandeur caractéristique correspondante de compteur ($KE_i$).

5. Compteur d'électricité selon la revendication 1, caractérisé en ce que la partie de mémorisation (17) est formée d'une mémoire de signaux avec accès aléatoire et en ce qu'outre les registres auxiliaires ($REH_i$) et les registres de correction ($RK_i$), le compteur de wattheures (WHZ) y est également contenu.

6. Procédé pour le calibrage du compteur d'électricité selon la revendication 1, caractérisé en ce que l'on entreprend le calibrage séparément pour chaque plage de mesure, en ce qu'au début on met le compteur de wattheures (WHZ) et les registres ($RK_i$, $REH_i$) à zéro et ensuite pendant une période prédéterminée de temps, on applique au compteur une tension définie de calibrage et on lui amène un courant défini de calibrage et en ce que l'on mémorise les masses d'énergie ($E_i$) accumulées lors du calibrage pendant cette période de temps en tant que grandeurs caractéristiques de compteur ($KE_i$) pour la plage correspondante de mesure.

7. Procédé selon la revendication 6, caractérisé en ce que l'on accumule la masse d'énergie ($E_i$) dans un registre auxiliaire ($REH_i$) et l'on mémorise la grandeur caractéristique du compteur ($KE_i$) dans un registre de correction ($RK_i$).

8. Procédé selon la revendication 6 ou 7, caractérisé en ce que l'on choisit le courant de calibrage de manière que la somme maximale de l'erreur de mesure à l'intérieur de toute plage de mesure soit minimisée.

9. Procédé selon la revendication 8, caractérisé en ce que l'on choisit le courant de calibrage de manière qu'il corresponde à la valeur moyenne de chaque plage de mesure.

**Claims**

1. Static electricity meter with an electronic measuring mechanism which exhibits an analog/digital converter (7) with series-connected amplifiers ($V_1$ to $V_4$) for various measuring ranges, a watthour meter (WHZ) and a control section with a microcomputer (8) which processes the signals of the measuring mechanism, taking into account correction values for the various elements of the circuit, characterized in that the measuring mechanism exhibits a storage section (17) with correction registers ($RK_i$) and with auxiliary registers ($REH_i$), that in the correction registers a meter characteristic ($KE_i$), which represents a numerical value corresponding to a defined quantity of energy and contains the respective correction value, is stored for each of the measuring ranges, and that the quantity of energy used is determined by comparing the energy ($E_i$) measured and accumulated in one of the auxiliary registers ($REH_i$) with the corresponding meter characteristic.

2. Electricity meter according to Claim 1, characterized in that the watthour meter (WHZ) exhibits several cells for various watthour ranges corresponding to the measuring ranges, and that, when the respective meter characteristic ($KE_i$) is exceeded by the accumulated energy ($E_i$), the numerical value corresponding to the meter characteristic ($KE_i$) is entered into the cell of the watthour meter associated with this meter characteristic.

3. Electricity meter according to Claim 2, characterized in that when the numerical value corresponding to the meter characteristic ($KE_i$) is entered into the corresponding cell of the watthour meter (WHZ), the energy ($E_i$) accumulated in the auxiliary register is reduced by the amount of the meter characteristic.

4. Electricity meter according to Claim 2 or 3, characterized in that in each case an auxiliary register ($REH_i$) for accumulating the current energy ($E_i$) and a correction register ($RK_i$) with the corresponding meter characteristic ($KE_i$) are provided for each measuring range.

5. Electricity meter according to Claim 1, characterized in that the storage section (17) is formed by a random-access signal memory and that it contains, in addition to the auxiliary registers ($REH_i$) and the correction registers ($RK_i$), also the watthour meter (WHZ).

6. Method for calibrating the electricity meter according to Claim 1, characterized in that the calibration is performed separately for each measuring range, the watthour meter (WHZ) and the registers ($RK_i$, $REH_i$) being set to zero at the beginning and subsequently a defined calibration voltage being applied to the meter and a defined calibration current being supplied to it during a particular time period, and that the quantity of energy ($E_i$) accumulated during this time period during the calibration is stored as meter characteristic ($KE_i$) for the measuring range concerned.

7. Method according to Claim 6, characterized in that the quantity of energy ($E_i$) is accumulated in an auxiliary register ($REH_i$) and the meter characteristic ($KE_i$) is stored in a correction register ($RK_i$).

8. Method according to Claim 6 or 7, characterized in that the calibration current is selected in such a manner that the maximum amount of the measuring error within the respective measuring range is minimized.

9. Method according to Claim 8, characterized in that the calibration current is selected in such a manner that it corresponds to the mean value of the respective measuring range.

FIG. 1

FIG. 2